# EUROPEAN PATENT APPLICATION

(11) **EP 3 203 323 A1**
(43) Date of publication of application: **09.08.2017**
(21) Application number: 17154017.2
(22) Date of filing: 31.01.2017
(51) Int. Cl.: G03F 9/00, B41J 11/00

(54) **METHOD FOR PRINTING AN IMAGE ON A SUBSTRATE ON A SUPPORT BODY**

(30) Priority: 03.02.2016 EP 16154141
(71) Applicant: OCE Holding B.V., 5914 CA Venlo (NL)
(72) Inventor: TREMBLAY, Christian, 5914 Venlo CA (NL); GRUAZ, Joris, 5914 Venlo CA (NL)
(74) Representative: OCE IP Department

(57) **Abstract**

Method is provided for printing an image on a substrate on a support body of a printing apparatus, the method comprising the steps of: providing a masking sheet on the support body; deriving from the image a boundary outline of the image; selecting a location on the support body for printing the image; printing the boundary outline of the image on the masking sheet at the selected location of the support body; printing at least one distance marker on at least one side of the printed boundary outline on the masking sheet, said distance marker indicating a distance from the boundary outline; placing the substrate on the masking sheet at the selected location of the support body using the boundary outline; determining an offset of the substrate relative to the printed boundary outline by way of the printed distance marker, after the substrate placing step; and printing the image on the substrate based on the determined offset of the substrate relative to the printed boundary outline.

## Description

### FIELD OF THE INVENTION

The present invention relates to a method for printing an image on a substrate on a support body of a printing apparatus. The present invention further relates to a printing apparatus for printing an image on a substrate on a support body of the printing apparatus

### BACKGROUND ART

A known printing apparatus comprises a support body for supporting a substrate and a print unit for printing an image on the substrate, when placed on the support body. The print unit comprises a carriage and a print head assembly, the carriage being movably arranged for moving the print head assembly relative to the support body in two directions. The print head assembly is facing the support body in printing operation and is arranged for applying an image material on the substrate based on the image to be printed.

The printing apparatus further comprises a processing unit arranged for controlling the print unit for positioning the image on a desired location on the support body, when the substrate has been placed on the support body. The processing unit controls the position of the print unit relative to the support body to print the image on the desired location. The substrate needs to be positioned accurately on the support body to enhance an accurate registering of the image to the substrate. The printing apparatus further comprises a suction unit for providing a suction force via suction holes, which are provided in the support body, to a contact side of the substrate, when the substrate is placed on the support body. The suction force holds the substrate stationary relative to the support body, thereby supporting an accurate registering of the image to the substrate.

Additionally, in a registering method of the substrate it is known to first place a masking sheet on the support body before placing the substrate on the masking sheet, for example, in case the substrate is smaller then the support body. Said masking sheet covers the suction holes of the support body and serves to sufficiently block off suction holes not being covered by the substrate. The masking sheet is semi-permeable for said suction force to communicate a part of the suction force to the substrate in order to hold the substrate onto the support table.

In a next step, the image is printed onto the masking sheet at a selected location. The printed image is used as a template to place and position the substrate onto the masking sheet at the selected location. In case the image on the masking sheet is completely covered by the substrate, the substrate is positioned at the selected location. In a next step, the image is printed a second time, the image being printed onto the substrate, which is positioned on the masking paper.

The registering method of the substrate onto the support body has the disadvantage that the image needs to be printed twice.

Furthermore a need exists to improve the accuracy of the registering of the image relative to the substrate. In case the image is considerably smaller than the substrate, a centered positioning of the image on the substrate becomes less accurate. Furthermore, substrates may have different shapes and sizes, which make the registering of the image relative to the substrate even more difficult.

### SUMMARY OF THE INVENTION

It is accordingly an object of the present invention to provide an improved method for printing an image on a substrate on a support body of a printing apparatus, the method providing an improved accuracy of registering the image relative to the substrate.

This object is attained by a method for printing an image on a substrate on a support body of a printing apparatus, the method comprising the steps of: a) providing a masking sheet on the support body; b) deriving from the image a boundary outline of the image; c) selecting a location on the support body for printing the image; d) printing the boundary outline of the image on the masking sheet at the selected location of the support body; e) printing at least one distance marker on at least one side of the printed boundary outline on the masking sheet, said distance marker indicating a distance from the boundary outline; f) placing the substrate on the masking sheet at the selected location of the support body using the boundary outline; g) determining an offset of the substrate relative to the printed boundary outline by way of the printed distance marker, after the substrate placing step f); and h) printing the image on the substrate based on the determined offset of the substrate relative to the printed boundary outline.

The boundary outline of the image is derived from the image to be printed in the image printing step h). The boundary outline indicates a boundary of the image. The boundary outline is printed on the masking paper at the selected location of the support body, thereby indicating the position of the image to be printed. The boundary outline is a boundary of the image, so it does not need all the image information to be printed onto the masking paper. Thus, the boundary outline uses less time to be printed and consumes less image material than a complete image.
Furthermore, the at least one distance marker is printed at a predetermined distance from the boundary outline so to indicate the distance from the boundary outline. The distance markers are used, after placing the substrate on the masking paper at the selected location, to accurately determine the offset of the substrate relative to the printed boundary outline. Finally, the image is printed on the substrate based on the offset of the substrate relative to the printed boundary outline. In this way, a simple and accurate registering of the image relative to the substrate is obtained.
For example, a manual positioning of the substrate at the selected location by way of the boundary outline only is not accurate and a certain offset in a first distance direction remains, for example an offset O₁ being +5 mm, which offset is indicated by the at least one distance marker. In the image printing step, the position of the printed image may be adjusted relative to the support body in the first distance direction by + 5 mm, thereby correcting the offset O₁ of the substrate. In this way, the printed image is accurately registered onto the substrate.
Preferably, an array of distance markers is printed and arranged along a first distance direction on the masking sheet, each distance marker indicating a distance from the boundary outline differing from any other distance marker of the array of distance markers.
The array of distance markers may be selected for improving the accuracy of the determining step of the offset, e.g. by reducing the distance between adjacent distance markers. Additionally or alternatively, the array of distance markers may be selected for enlarging the distance range for the determining step of the offset, when the array of distance markers extends over a longer distance.

In an embodiment, the boundary outline comprises two lines crossing one another for indicating the boundary of the image at one of its corners. The two lines cross one another, thereby indicating the boundary of the image at one of its corners. For example, the two lines may cross one another at an angle of 90 degrees, thereby providing aligning lines for a rectangular shaped substrate. In examples, the two crossing lines may be connected to one another and the two crossing lines may intersect one another.

In an embodiment, the boundary outline comprises a boundary box enclosing the image. The boundary box encloses the area of the image. For example, the boundary box may comprise a solid line enclosing the image and the boundary box may comprise an interrupted line enclosing the image. The boundary box supports a simple way of aligning edges of the substrate relative to the boundary outline. The boundary box may have a rectangular shape, may have a round shape and may have any other suitable shape for enclosing the area of the image to be printed.

In an embodiment, the boundary outline is selected based on a predetermined shape of the substrate. The boundary outline is adapted based on the predetermined shape of the substrate. For example, in case the substrate is shaped rectangular, the boundary outline comprises lines for indicating the boundary of the image, which lines are arranged orthogonally to one another. In another example, in case the substrate is shaped circular, the boundary outline comprises a circular shape, such as a circular line or a set of markers, which together form a circular shape.

In an embodiment, step e) comprises printing a first distance marker at a first side of a part of the boundary outline and a second distance marker at a second side of said part of the boundary outline, the second side being opposite to the first side along a first distance direction.
In this way, distance markers are printed on both sides of said part of the boundary outline along the first distance direction. The distance markers indicate a distance at both sides of said part of the boundary outline in the first distance direction. The part of the boundary outline may, for example, be a line indicating one side of the area of the image. The distance markers of this embodiment support determining the offset of the substrate independent of which position along the first distance direction the offset is present relative to the boundary outline. So, the offset may be arranged in a negative direction or a positive, opposite, direction relative to the part of the boundary outline.

In an embodiment, in step e) a first array of distance markers is arranged along a first distance direction and a second array of distance markers is arranged along a second distance direction, which is different from the first distance direction. The first array and second array of distance markers support determining the offsets of the substrate in respectively the first distance direction and the second distance direction. In this way, the registering of the image onto the substrate in the printing step is possible in both the first distance direction and the second distance direction. For example, the offset to a rectangular shaped boundary box is easily determined, by positioning the first array of distance markers relative to a first line of the boundary box and positioning the second array of distance markers relative to a second line of the boundary box, wherein the first line is arranged orthogonal to the second line. In this way, the image may be accurately positioned on a rectangular shaped substrate, which is placed on the masking sheet at the selected location.

In an embodiment, in step f) the substrate is placed at a desired offset from the boundary outline by way of the at least one distance marker, and wherein in step h) the location of the printed image is based on the desired offset. The desired offset may be a desired margin at one side of the substrate. The substrate may be positioning by way of the at least one distance marker, such that the offset obtained is the desired margin of the image relative to the substrate at the respective side of the substrate. In this way, the at least one distance marker support an accurate selection of the desired offset of the substrate relative to the image printed in step h). In an example, an array of distance markers may be provided in order to more accurately place the substrate and determine the obtained offset and to compare the obtained offset to the desired offset. In a further embodiment, the distance of a first distance marker relative to the boundary outline is selected based on the desired offset.
In a further embodiment, the method further comprises the step of selecting a margin and the printing step h) comprises adjusting the image position relative to the outline boundary based on the selected margin. The selected margin is compared to the offset determined. When the offset is not the same as the selected margin, the image position of printing step h) is adjusted relative to the outline boundary based on the selected margin and the offset determined in step g).

In an embodiment, in step g) the offset is determined by an operator and provided to a processing unit arranged for printing the image on the substrate during step h) based on the received offset. The operator may visually determine the offset of the substrate relative to the boundary outline. The operator provides the offset to the processing unit, e.g. by way of a user interface, which is connected to the processing unit. In this way, determining the offset is easily carried out and the result is known to the processing unit to be used for the image printing step. In an example, in case more than one array of distance markers is used, each indicating a different offset of the substrate relative to the boundary outline, each array of distance markers may be labeled by printing a label adjacent to it during step e), thereby indicating the specific array of distance markers. These labels support a reliable input of the set of offsets by the operator to the processing unit.

In another embodiment, in step g) the offset is detected by a sensor, which is operatively connected to a processing unit arranged for printing the image on the substrate during step h) based on the detected offset. The sensor detects the offset after the substrate has been placed on the masking sheet. In examples, the sensor may be a camera facing the support body and may be a sensor movably arranged on a carriage for moving relative to the support body, wherein the sensor detects the substrate and the distance markers in order to determine the offset. The sensor supports an accurate determination of the offset without the use of an operator.

In an embodiment, step g) comprises determining offsets of both sides of the substrate, respectively, in a first distance direction by way of a set of distance markers, the sides of the substrate being opposite of one another in the first distance direction; and the method further comprises the step of determining the size of the substrate in the first distance direction based on the offsets determined in step g).
The offsets determined of both sides of the substrate in the first distance direction provide an accurate measure of the size of the substrate in the first distance direction. The determined size of the substrate in the first distance direction may be used to adapt the image in the first distance direction. This is very useful in case the size of the substrate in the first distance direction is different than expected, e.g. if the size is different from the size of the image in the first distance direction.

In a further embodiment, the printing step h) comprises adjusting the printed image in the first distance direction based on the determined size of the substrate.
In examples, the adjusting step of the printed image may comprise scaling the image in the first distance direction based on the determined size of the substrate, may comprise cropping the image in the first distance direction based on the determined size of the substrate and may comprise adding image area to the image in the first distance direction based on the determined size of the substrate.
In case of scaling the image, if the size of the substrate in the first distance direction is different than expected, the image printed in step h) is scaled to the determined size of the substrate. For example, if the substrate is shorter along the first distance direction relative to the boundary outline, the image size may be reduced. In examples, the image size may be reduced in the first distance direction only and may be reduced such that a height direction and a width direction of the image maintain a constant aspect ratio between one another.
In case of cropping the image, e.g. if the size of the substrate in the first distance direction is less than the image size in the first distance direction, a part of the image arranged on at least one of the sides of the image along the first distance direction may be cropped.
In case of adding image area to the image, e.g. if the size of the substrate in the first distance direction is more than the image size in the first distance direction, an additional area of the image along the first distance direction may be added adjoining to one of the sides of the original image in the first distance direction. The additional area of the image may contain colour information substantially equal to colour information of an image area at the side of the image along the first distance direction, such as by mirroring outer pixels at the sides of the image relative to the boundary outline of the original image.

In an embodiment, during steps g) - h) a suction force is provided from the support body to the masking sheet, and wherein the masking sheet is semi-permeable for said suction force to communicate a part of the suction force to the substrate placed on the masking sheet, which is maintained stationary relative to the support body by the suction force. The masking sheet being semi-permeable for said suction force supports a reliable positioning of the masking sheet and the substrate on the support body. As the masking sheet and the substrate are both held stationary by the suction force, the accurate registering of the image on the substrate in the printing step h) is supported. Additionally, preferably the suction force may be provided from the support body to the masking sheet during steps d) - e). In this way, the masking sheet is maintained stationary relative to the support body by the suction force during these steps. Alternatively, the masking sheet may be held stationary relative to the support body during steps d) - e) by fastening means, such as tape.

Optionally, during step f) the masking sheet may be held stationary relative to the support body by fastening means, such as tape, without applying a suction force from the support body to the masking sheet. In this way, positioning of the substrate on the masking sheet during step f) is enhanced.

In another aspect of the present invention a printing apparatus is provided for printing an image on a substrate to be placed on a support body of the printing apparatus, the printing apparatus comprising: a support body for supporting the substrate; a print unit for printing an image on the substrate, when placed on the support body; and a processing unit arranged for: deriving from the image a boundary outline of the image; determining a location on the support body for printing the image; controlling the print unit to print the boundary outline and at least one distance marker at the predetermined location on the masking sheet, when the masking sheet has been placed on the support body, said distance marker being arranged for indicating a distance from the boundary outline; and controlling the print unit to print the image on the substrate, when the substrate is placed on the masking paper on the support body, based on a determined offset of the substrate relative to the printed boundary outline.
The processing unit derives the boundary outline of the image based on the image to be printed on the substrate. In examples, the boundary outline may comprise a boundary box according to the present invention and may comprise two lines crossing one another for indicating the boundary of the image at one of its corners. Preferably, the boundary outline, which is to be printed on the masking paper, is selected based on the shape of the substrate. Said shape of the substrate may be provided by an operator to the processing unit or may be selected by the processing unit from a data base of predetermined shapes. The location on the support body for printing the image may be selected by the processing unit and may be provided by an operator to the processing unit. The location of the at least one distance marker printed may be selected by the processing unit and may be provided by an operator to the processing unit. In any way, the location of the printed distance marker is selected for indicating a distance from the boundary outline. When the offset is determined, after the substrate is placed on the masking paper on the support body, the processing unit controls the print unit to print the image on the substrate based on a determined offset of the substrate relative to the printed boundary outline. In an example, the printing unit may comprise a print head assembly for printing the image and a carriage for moving the print head assembly relative to the support body.

The printing apparatus supports an accurate registering of the image on the substrate.

In an embodiment, the printing apparatus further comprises a sensor for detecting the offset of the substrate relative to the printed boundary outline, when the substrate has been placed on the masking sheet at the predetermined location, which sensor is operatively connected to the processing unit. The sensor detects the offset after the substrate has been placed on the masking sheet. In examples, the sensor may be a camera facing the support body and may be a sensor movably arranged on a carriage for moving relative to the support body, wherein the sensor detects the substrate and the distance markers in order to determine the offset. The sensor supports an accurate determination of the offset by the printing apparatus.

In an embodiment, the printing apparatus further comprises a user interface for receiving from an operator the offset of the substrate relative to the printed boundary outline, when the substrate has been placed on the masking sheet at the predetermined location, which user interface is operatively connected to the processing unit. The operator provides the offset to the processing unit by way of the user interface, which is connected to the processing unit. In this way, determining the offset is easily carried out and the result is provided to the processing unit to be used for the image printing step.

Further scope of applicability of the present invention will become apparent from the detailed description given hereinafter. However, it should be understood that the detailed description and specific examples, while indicating embodiments of the invention, are given by way of illustration only, since various changes and modifications within the scope of the invention will become apparent to those skilled in the art from this detailed description.

### BRIEF DESCRIPTION OF THE DRAWINGS

Hereinafter, the present invention is further elucidated with reference to the appended drawings showing non-limiting embodiments and wherein
- Fig. 1: shows a schematic view of a prior art print engine in which a method according to the invention may be used.
- Figs. 2A- 2B: schematically show an embodiment of an apparatus and a method to be used in the apparatus according to the present invention.
- Figs. 3A - 3C: schematically show an embodiment of the method to be used to derive an outline boundary according to the present invention.
- Figs. 4A - 4C: schematically show another embodiment of the method to be used to derive an outline boundary according to the present invention.
- Figs. 5A - 5D: schematically show several embodiments of the distance markers to be used in the method according to the present invention.
- Figs. 6A - 6B: schematically show an embodiment of positioning the substrate relative to the boundary outline according to the present invention.
- Figs. 7A - 7B: schematically show an embodiment of scaling the image according to the present invention.

### DETAILED DESCRIPTION OF EMBODIMENTS

The present invention will now be described with reference to the accompanying drawings, wherein the same reference numerals have been used to identify the same or similar elements throughout the several views.

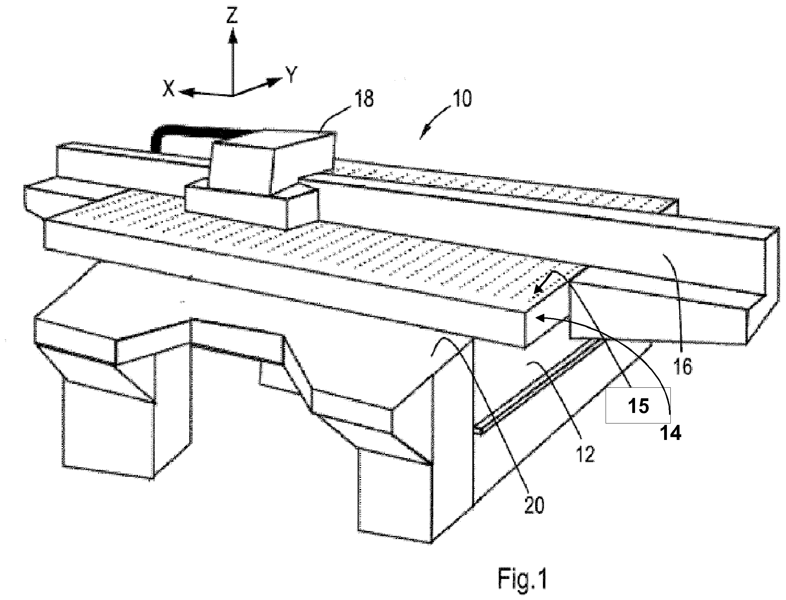

Fig. 1 shows a printing device 10 for printing an image or text on a relatively large substrate, in particular on a relatively large and flat substrate. Such a printing device 10 is well known in the art. The printing device 10 comprises a support assembly 12 on which a support body 14 is mounted comprising a printing surface 15 for supporting said substrate. As illustrated, the printing surface 15 may be provided with suction holes for pulling the substrate onto the printing surface 15 and thereby holding the substrate flat on the printing surface 15 of the support body 14. A guiding assembly 16 is provided for supporting and guiding a carriage 18. The carriage 18 is movably supported by the guiding assembly 16 such that the carriage 18 may be moved over the printing surface 15. For example, the guiding assembly 16 may be movably supported on the support assembly 12 such that the guiding assembly may be moved in a y-direction (as indicated in Fig. 1) and the carriage 18 may be moveably supported by the guiding assembly 16 such that the carriage may be moved in a x-direction guided by the guiding assembly 16. The carriage 18 is provided with a printing element such as an inkjet print head for printing the image or the text on the substrate arranged on the printing surface 15 by ejecting ink drops at preselected positions. It is noted that the guiding assembly 16 and / or the carriage 18 may be supported such that they may be moved in a z-direction, thereby enabling to print on different media (i.e. substrates) having a different dimension in the z-direction (when positioned on the printing surface 15).

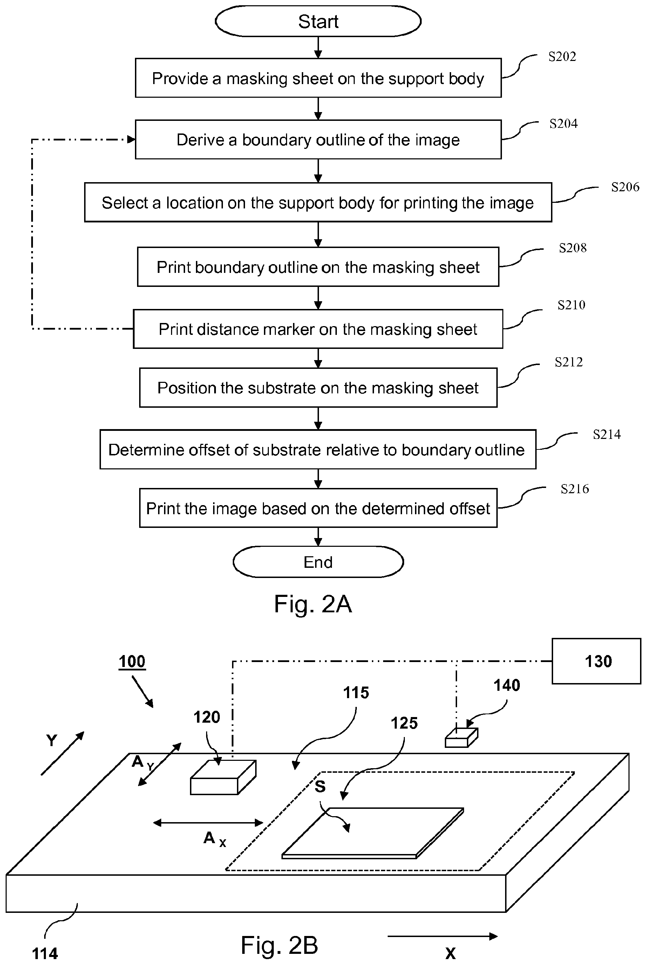

Fig. 2A shows an embodiment of the method according to the present invention and Fig. 2B shows a schematic perspective view of a printing apparatus according to the present invention. The printing apparatus 100 comprises a support body 114 for supporting a substrate S on a support surface 115 of the support body 114, a print unit 120, a processing unit 130 and optionally a sensor 140. The support body 114 including the support surface 115 extends in a direction X and a direction Y normal to the direction X. Said print unit 120 is arranged facing the support surface 115 and is movably arranged with respect to the support surface 115 of the support body 114 as indicated by arrows Aₓ and A_{y}. The direction Aₓ is parallel to the direction X and the direction A_{y} is parallel to the direction Y of the support surface 115. The print unit 120 is provided with a printing element such as an inkjet print head for printing the image or the text on the substrate arranged on the support surface 115 by ejecting ink drops at preselected positions. The processing unit 130 is operatively connected to the print unit 120 for controlling the print unit 120 to move over the support surface 115 and to print an image on the substrate S. The processing unit 130 is further operatively connected to the sensor 140. The support body 114 comprises a plurality of suction holes (not shown), which are distributed over the support surface 115 of the support body 114. The suction holes are operatively connected to a suction source (not shown) for providing a suction force to a substrate or any other object placed on the support surface 115.

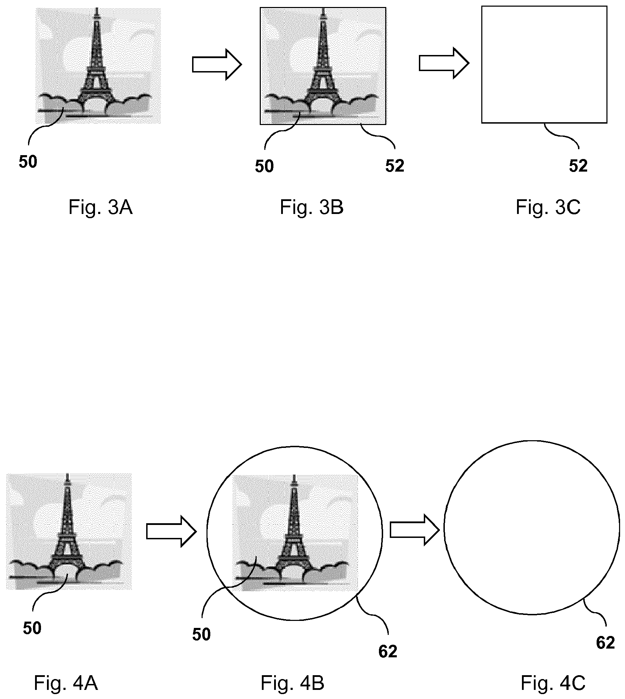

Now referring to the flowchart shown in Figure 2A, in a first step S202 of the method a masking sheet 125 is placed on the support surface 115 of the support body 114. The masking sheet 125 may be placed on the support body 114 by an operator and may be placed on the support body 114 by an additional positioning device, which is controlled by the processing unit 130. When the masking sheet 125 is placed on the support surface 115, the masking paper covers at least a part of the support surface 115. The masking paper 125 is preferably attracted to the support surface 115 by providing a suction force through the suction holes distributed over the support surface 115. In an example, the masking sheet is semi-permeable for said suction force to communicate a part of the suction force through the masking sheet to any substrate placed on the masking sheet 125. The suction force may be provided after the masking sheet 125 has been placed on the support surface 115 and the suction force may be provided before the masking sheet 125 has been placed on the support surface 115. When the suction force is provided, the masking sheet 125 is maintained stationary with respect to the support body 114.
In a next step S204, the processing unit derives a boundary outline from an image to be printed. The boundary outline is selected to indicate a boundary of the image. The boundary outline preferably encloses the area of the image. The boundary outline may comprise a boundary box enclosing the area of the image.
An example of deriving the boundary outline from the image is shown in Figs. 3A - 3C. Fig. 3A shows schematically an image 50 to be printed. The image 50 extends over a certain image area. As shown in Fig. 3B, from the area of the image 50 a boundary box 52 is derived, which encloses the area of the image 50. The boundary box 52 has a rectangular shape. The rectangular shape of the boundary box 52 may be selected based on a known shape of the substrate S to be printed on. Figure 3C shows the boundary box 52 which is established, wherein the image 50 is removed from the data to be printed.
Another example of deriving the boundary outline from the image is shown in Figs. 4A - 4C. Fig. 4A shows the same image 50 to be printed. As shown in Fig. 4B, from the area of the image 50 another boundary box 62 is derived, which encloses the area of the image 50. The boundary box 62 has a circular shape. The circular shape of the boundary box 52 may be selected based on a known circular shape of the substrate S to be printed on. Figure 4C shows the boundary box 62 which is established, wherein the image 50 is removed from the data to be printed.
In step S206 a location on the support body 114 is selected for printing the image. The location may be selected by the processing unit 130 based on a shape and / or a size of the substrate S to be printed on.

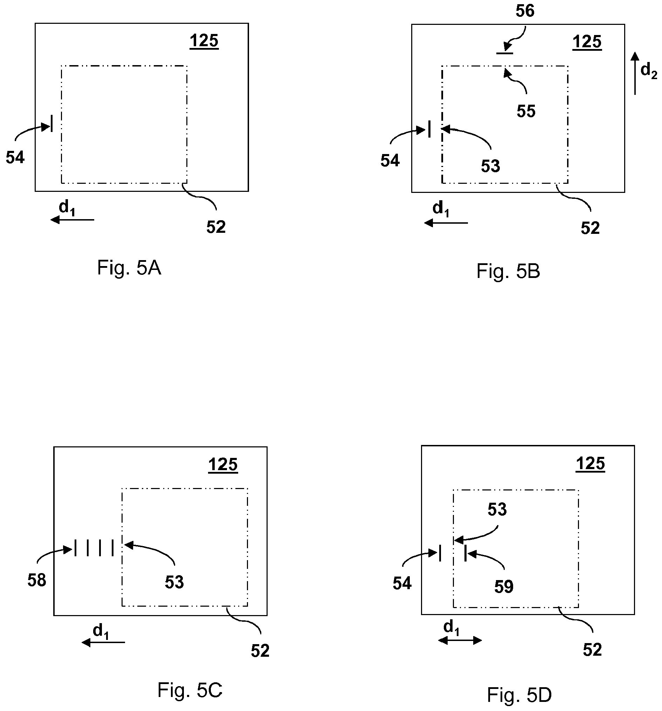

Instead of the order of steps S202-S206, step S206 may be performed prior to steps S202 and S204 and step S204 may be performed prior to steps S202 and S206. The order of these steps S202 - S206 is interchangeable.
In step S208 the boundary outline established in step S204 is printed on the masking sheet 125 at the selected location on the support body 114. The boundary outline printed on the masking sheet 125 indicates the selected position of the image on the support body 114.
In step S210 at least one distance marker is printed on the masking sheet 125 at the selected location. The position of the at least one distance marker on the support body 114 is selected relative to the boundary outline 52, 62 to indicate a distance from the boundary outline 52, 62. For example as shown in Figure 5A, which shows a plane view on the masking sheet 125, the distance marker 54 is printed at a certain distance from a line segment of the boundary box 52, said distance being arranged along the first distance direction d₁. In another example, as shown in Figure 5B, which shows a plane view on the masking sheet 125, a first distance marker 54 is printed at a certain distance from a first line segment 53 of the boundary box 52, said distance being arranged along a first distance direction d₁, and a second distance marker 56 is printed at a certain distance from a second line segment 55 of the boundary box 52, said distance being arranged along a second distance direction d₂. The second distance direction d₂ is perpendicular to the first distance direction d₁. Depending on an orientation of the image relative to the support body 114, the first distance direction d₁ may be arranged parallel to the direction x or parallel to the direction y as indicated in Figure 2B or may be arranged in any other direction. In a third example as shown in Figure 5C, which shows a plane view on the masking sheet 125, a plurality of distance markers 58 is printed at a differing distances from a first line segment 53 of the boundary box 52, said plurality of distance markers 58 being arranged along the first distance direction d₁ relative to the first line segment 53 of the boundary box 52. The interval between adjacent markers of the plurality of distance markers 58 may be constant. Each of the plurality of distance markers 58 indicates a different distance to the first line segment 53 of the boundary box 52.
In a fourth example as shown in Figure 5D, a first distance marker 54 is printed at a first side from a first line segment 53 of the boundary box 52 and a second distance marker 59 is printed at a second side from the first line segment 53 of the boundary box 52, the second side being opposite to the first side along a first distance direction d₁. The first distance marker 54 and second distance marker 59 indicate a distance to the boundary box 52 at both sides of the first line segment 53 of the boundary box 52. The distance markers 54, 59 support determining an offset relative to the first line segment 53 of the boundary box 52 independent of the direction of the substrate S relative to the first line segment 53 of the boundary box 52 along the first distance direction d₁.

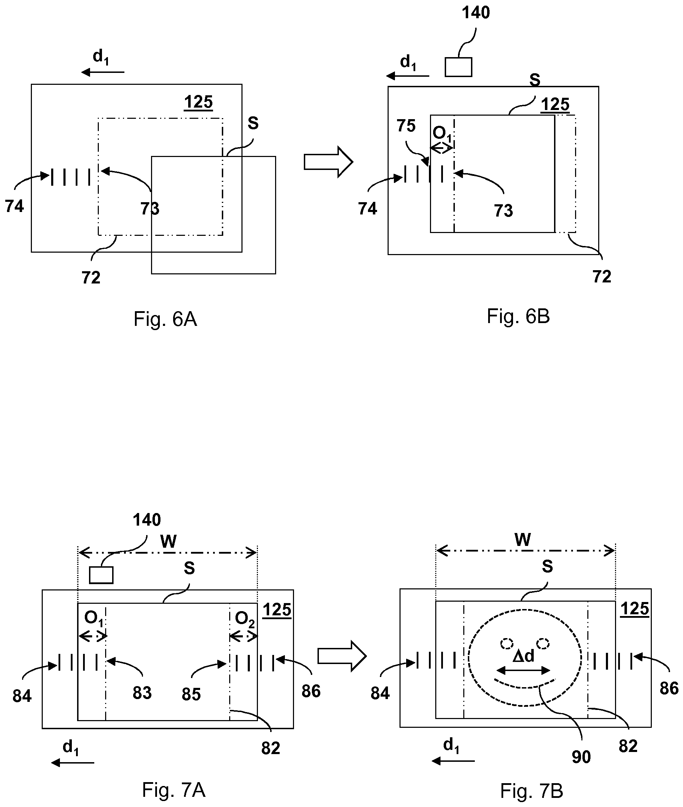

In step S210 additionally a label may be printed next to one or more of the distance markers onto the masking sheet 125 to indicate the specific distance indicated by the respective distance marker. For example, if the distance is 5 mm, this may be printed next to the distance marker.
In step S212 the substrate S is placed and positioned on the masking sheet 125 using the boundary outline 52, 62. The substrate S may be positioned manually by an operator. Alternatively the substrate S may be placed on the masking sheet 125 by an additional positioning device, e.g. which is controlled by the processing unit 130. When the substrate S is positioned, the substrate S at least partly covers the boundary box 52, 62. Preferably the substrate S is placed completely covering the boundary box 52, 62. However, a substrate S being smaller than the boundary box 52, 62 cannot cover the boundary box 52, 62 completely. Even if the substrate S is positioned rather accurate, still a misalignment of the substrate S to the boundary box 52, 62 may occur. In step S214 an offset of the substrate S relative to the boundary box is determined by way of the at least one distance marker.
For example, in the example shown in Figures 6A and 6B, which show a plane view on the masking sheet 125, the substrate S is positioned on the masking sheet 125 using the boundary box 72. As shown in Figure 6A, the boundary box 72 is first printed on the masking sheet 125. Next to a first line segment 73 of the boundary box 72 a plurality of distance markers 74 is printed on the masking sheet 125. The plurality of distance markers 74 is distributed along a first distance direction d₁ to indicate a distance to the first line segment 73 of the boundary box 72. As shown in Figure 6B the substrate S, after being placed on the masking sheet 125, has an offset in the first distance direction d₁ of a certain distance to the first line segment 73 of the boundary box 72. The offset O₁ is determined by detecting, such as detecting by use of a sensor 140, which marker 75 of the distance markers 74 is closest to the edge of the substrate S. Said distance marker 75 indicates the offset O₁ of the substrate in the first distance direction d₁.
The offset may be detected by sensor 140, which sends a signal to the processing unit 130 based on the detected offset. Alternatively, the offset may be detected visually by an operator and may be provided to the processing unit 130 by way of a user interface (not shown).
Likewise a second offset O₂ of a second edge of the substrate may be determined by way of a second set of distance markers printed on the masking sheet 125 (not shown). Additionally or alternatively a second offset O₂ of the same edge of the substrate S may be determined at a second, different, position along said edge of the substrate S by way of a second set of distance markers printed on the masking sheet 125. The second offset O₂ and the first offset O₁ may be used to determine a skew orientation of said edge of the substrate relative to the boundary outline. In a next step S216, the image is printed on the substrate based on the offset or offsets determined in step S214. For example, if the offset is more than zero, the printing position of the image relative to the support body may be shifted over a distance in the corresponding direction equal to the determined offset in said direction. In particular, the print unit 120 is controlled in step S216 by the processing unit 130 to print the image on the substrate S based on the determined offset.

In a further example of the method, as shown in Figures 7A and 7B, which show a plane view on the masking sheet 125, a boundary box is printed 82 on the masking sheet 125. Furthermore a first plurality of distance markers 84 is printed at differing distance to a first line segment 83 of the boundary box 82 and a second plurality of distance markers 86 is printed at differing distance to a second line segment 85 of the boundary box 82. The first line segment 83 is arranged at a first side of the boundary box 82 along the first distance direction d₁ and the second line segment 85 is arranged at a second side of the boundary box 82, the second side being opposite to the first side along the first distance direction d₁. As shown in Figure 7A, the substrate S is positioned on the masking sheet 125 by using the boundary box 82. The substrate S has a width along the first distance direction d₁, which is larger than the width of the boundary box 82 in said first distance direction d₁. When the substrate S is positioned on the masking sheet 125, a first offset O₁ is determined of a first edge of the substrate S relative to the first line segment 83 by way of the first plurality of distance markers 84. Furthermore, a second offset O₂ is determined of a second edge of the substrate S relative to the second line segment 85 by way of the second plurality of distance markers 86.
Based on the first offset O₁ and the second offset O₂ a width W of the substrate S along the first distance direction d₁ is determined by the processing unit 130. The processing unit 130 changes the scale of the image, as indicated by arrow Δd, in the first distance direction d₁ based on the width W of the substrate S. As indicated in Figure 7B the image 90 is scaled in the first distance direction d₁, such that the image 90 entirely covers the substrate S.
Additionally the image 90 may be scaled in another direction, e.g. the image 90 may be scaled in a direction perpendicular to the first distance direction d₁ in order to maintain the aspect ratio of the image 90 constant.

In a modified example of the embodiment shown in Figs. 7A and 7B, the image is smaller than the substrate S along the first distance direction d1 as indicated in Fig. 7A by the offsets O₁ and O₂. However the image 90 is not scaled to the size of the substrate S in the first distance direction d1. Instead, the first offset O₁ and second offset O₂ is used to centre the image 90 relative to the substrate S along the first distance direction d₁ in step S216 without scaling the image 90 in the first distance direction d₁.

Optionally the image 90 may both be centered in step S216 relative to the substrate S along the first distance direction d₁ in combination with scaling the image 90 in the first distance direction d₁, as indicated by arrow Δd, based on the width W of the substrate S.

Alternatively to the method shown in Figure 2B, steps S204 - S210 may be repeated before steps S212 - S216 in order to print a second boundary outline of a second image on the masking sheet 125 including at least one distance marker. For the second image in step S206 a second location is selected different from a first location of the first image to be printed on the first substrate. The first boundary outline and the second boundary outline may be printed on the masking sheet 125 simultaneously and may be printed subs sequent to one another.
In step S212 the first substrate is positioned on the masking sheet 125 by way of the first boundary outline derived from the first image and the second substrate is placed on the same masking sheet 125 by way of a second boundary outline derived from the second image. In step S214 a first offset is determined of the first substrate relative to the first boundary outline and a second offset is determined of the second substrate relative to the second boundary outline. Likewise, in step S216 the first image is printed on the first substrate based on the first offset and the second image is printed on the second substrate based on the second offset.

Detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. In particular, features presented and described in separate dependent claims may be applied in combination and any advantageous combination of such claims are herewith disclosed.
Further, the terms and phrases used herein are not intended to be limiting; but rather, to provide an understandable description of the invention. The terms "a" or "an", as used herein, are defined as one or more than one. The term plurality, as used herein, is defined as two or more than two. The term another, as used herein, is defined as at least a second or more. The terms including and/or having, as used herein, are defined as comprising (i.e., open language). The term coupled, as used herein, is defined as connected, although not necessarily directly.
The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. Method for printing an image on a substrate (S) on a support body (114) of a printing apparatus (100), the method comprising the steps of:
a) providing a masking sheet (125) on the support body (114);
b) deriving from the image a boundary outline of the image;
c) selecting a location on the support body (114) for printing the image;
d) printing the boundary outline of the image on the masking sheet (125) at the selected location of the support body (114);
e) printing at least one distance marker on at least one side of the printed boundary outline on the masking sheet (125), said distance marker indicating a distance from the boundary outline;
f) placing the substrate (S) on the masking sheet (125) at the selected location of the support body (114) using the boundary outline;
g) determining an offset of the substrate (S) relative to the printed boundary outline by way of the printed distance marker, after the substrate (S) placing step f); and
h) printing the image on the substrate (S) based on the determined offset of the substrate (S) relative to the printed boundary outline.

2. The method according to claim 1, wherein the boundary outline comprises two lines crossing one another for indicating the boundary of the image at one of its corners.

3. The method according to any one of claims 1 or 2, wherein the boundary outline comprises a boundary box enclosing the image.

4. The method according to any one of claims 1 - 3, wherein the boundary outline is selected based on a predetermined shape of the substrate (S).

5. The method according to any one of claims 1 - 4, wherein step e) comprises printing a first distance marker at a first side of a part of the boundary outline and a second distance marker at a second side of said part of the boundary outline, the second side being opposite to the first side along a first distance direction.

6. The method according to any one of claims 1 - 5, wherein in step e) a first array of distance markers is arranged along a first distance direction and a second array of distance markers is arranged along a second distance direction, which is different from the first distance direction.

7. The method according to any one of the preceding claims, wherein in step f) the substrate (S) is placed at a desired offset from the boundary outline by way of the at least one distance marker, and wherein in step h) the location of the printed image is based on the desired offset.

8. The method according to any one of the preceding claims, wherein in step g) the offset is determined by an operator and provided to a processing unit arranged for printing the image on the substrate (S) during step h) based on the received offset.

9. The method according to any one of the preceding claims, wherein in step g) the offset is detected by a sensor, which is operatively connected to a processing unit arranged for printing the image on the substrate (S) during step h) based on the detected offset.

10. The method according to any one of the preceding claims, wherein step g) comprises determining offsets of both sides of the substrate (S), respectively, in a first distance direction by way of a set of distance markers, the sides of the substrate (S) being opposite of one another in the first distance direction; and the method further comprises the step of determining the size of the substrate (S) in the first distance direction based on the offsets determined in step g).

11. The method according to claim 10, wherein the printing step h) comprises adjusting the printed image in the first distance direction based on the determined size of the substrate (S).

12. The method according to any one of the preceding claims, wherein during steps g) - h) a suction force is provided from the support body (114) to the masking sheet (125), and wherein the masking sheet (125) is semi-permeable for said suction force to communicate a part of the suction force to the substrate (S) placed on the masking sheet (125), which is maintained stationary relative to the support body (114) by the suction force.

13. A printing apparatus (100) for printing an image on a substrate (S) on a support body (114) of the printing apparatus (100), the printing apparatus (100) comprising:
- a support body (114) for supporting the substrate (S);
- a print unit for printing an image on the substrate (S), when placed on the support body (114); and
- a processing unit arranged for:
- deriving from the image a boundary outline of the image;
- determining a location on the support body (114) for printing the image;
- controlling the print unit to print the boundary outline and at least one distance marker at the predetermined location on the masking sheet (125), when the masking sheet (125) has been placed on the support body (114), said distance marker being arranged for indicating a distance from the boundary outline; and
- controlling the print unit to print the image on the substrate (S), when the substrate (S) is placed on the masking paper on the support body (114), based on a determined offset of the substrate (S) relative to the printed boundary outline.

14. The printing apparatus (100) according to claim 13, wherein the printing apparatus (100) further comprises a sensor for detecting the offset of the substrate (S) relative to the printed boundary outline, when the substrate (S) has been placed on the masking sheet (125) at the predetermined location, which sensor is operatively connected to the processing unit.

15. The printing apparatus (100) according to claim 13, wherein the printing apparatus (100) further comprises a user interface for receiving from an operator the offset of the substrate (S) relative to the printed boundary outline, when the substrate (S) has been placed on the masking sheet (125) at the predetermined location, which user interface is operatively connected to the processing unit.
